# EUROPEAN PATENT SPECIFICATION

(11) **EP 4 495 959 B1**
(45) Date of publication and mention of the grant of the patent: **18.03.2026**
(21) Application number: 23770154.5
(22) Date of filing: 07.02.2023
(51) Int. Cl.: H10N 60/20, H01B 12/06, H01F 6/06

(54) **SUPERCONDUCTING WIRE AND SUPERCONDUCTING DEVICE INCLUDING THE SAME**
SUPRALEITENDER DRAHT UND SUPRALEITENDE VORRICHTUNG MIT DIESEM
FIL SUPRACONDUCTEUR ET DISPOSITIF SUPRACONDUCTEUR LE COMPRENANT

(30) Priority: 14.03.2022 JP 2022039195
(43) Date of publication of application: 22.01.2025
(73) Proprietor: SUMITOMO ELECTRIC INDUSTRIES, LTD., Osaka-shi, Osaka 541-0041 (JP)
(72) Inventor: YAMAGUCHI, Takashi, Osaka-shi, Osaka 541-0041 (JP)
(74) Representative: Grünecker Patent- und Rechtsanwälte PartG mbB
(86) International application number: PCT/JP2023/003941
(87) International publication number: WO 2023/176193

(56) References cited:
- WO-A1-2013/129568
- WO-A1-2014/003049
- WO-A1-2023/176194
- JP-A- 2012 064 519
- JP-A- 2012 241 234
- JP-A- 2012 252 825
- JP-A- 2018 206 670

## Description

### TECHNICAL FIELD

The present invention relates to a superconducting wire and a superconducting device including the superconducting wire. The present application claims priority based on Japanese Patent Application No. 2022-039195 filed on March 14, 2022.

### BACKGROUND ART

A superconducting wire having a substrate and a superconducting layer thereon is known from PTL1 to PTL 3, for example. In PTL 2 and PTL 3 the substrate back surface has an arithmetic average surface roughness (Rₐ) in a range of 50 nm to 1 µm and 1 nm to 1 µm, respectively, formed by polishing.

### CITATION LIST

### PATENT LITERATURE

PTL 1: Japanese Patent Application 2014-220194 A
PTL 2: Japanese Patent Application 2012-252825 A
PTL 3: Japanese Patent Application 2018-206670 A

### SUMMARY OF INVENTION

A superconducting wire according to the present invention comprises a substrate and a superconducting layer. The substrate includes a first surface and a second surface. The second surface is opposite to the first surface. The superconducting layer faces the first surface. The second surface has an arithmetic average roughness larger than 0.02 µm and a maximum height roughness smaller than 5 µm.

### BRIEF DESCRIPTION OF DRAWINGS

Fig. 1 is a schematic cross section of a configuration of a superconducting wire according to a first embodiment.
Fig. 2 is a schematic cross section of a configuration of a superconducting wire according to a second embodiment.
Fig. 3 is a schematic cross section of a configuration of a superconducting wire according to a third embodiment.
Fig. 4 is a schematic cross section of a configuration of a superconducting wire according to a fourth embodiment.
Fig. 5 is a schematic cross section of a configuration of a superconducting device according to a fifth embodiment.

### DETAILED DESCRIPTION

### [Problem to be Solved by the Present Invention]

The superconducting wire disclosed in PTL 1 to PTL 3 may have an insulating resin layer peeled.

The present invention has been made in view of overcoming such a problem as described above and contemplates a superconducting wire capable of suppressing peeling of an insulating resin layer.

### [Advantageous Effect of the Present Invention]

According to the present invention, a superconducting wire capable of suppressing peeling of an insulating resin layer can be provided.

### [Description of Embodiments of the Present Invention]

Initially, embodiments of the present invention will be enumerated and described.
(1) According to the present invention, a superconducting wire 100 comprises a substrate 1 and a superconducting layer 3. Substrate 1 has a first surface 11 and a second surface 12. Second surface 12 is opposite to first surface 11. Superconducting layer 3 faces first surface 11. Second surface 12 has an arithmetic average roughness larger than 0.02 µm. Second surface 12 has a maximum height roughness smaller than 5 µm.
(2) In superconducting wire 100 according to (1), second surface 12 may have an arithmetic average roughness smaller than 3 µm.
(3) Superconducting wire 100 according to (1) or (2) may further comprise a stabilization layer 5. Stabilization layer 5 may surround substrate 1 and superconducting layer 3. Stabilization layer 5 may include a third surface 13 and a fourth surface 14. Third surface 13 may face second surface 12. Fourth surface 14 may be opposite to third surface 13.
(4) In superconducting wire 100 according to (3), fourth surface 14 may have an arithmetic average roughness larger than 0.02 µm.
(5) In superconducting wire 100 according to (3) or (4), fourth surface 14 may have an arithmetic average roughness smaller than 1.5 µm.
(6) In superconducting wire 100 according to any one of (3) to (5), fourth surface 14 may have a maximum height roughness smaller than 8 µm.
(7) Superconducting wire 100 according to any one of (3) to (6) may further comprise an intermediate layer 2 and a protective layer 4. Intermediate layer 2 may be provided between substrate 1 and superconducting layer 3. Protective layer 4 may be provided on superconducting layer 3. Stabilization layer 5 may surround intermediate layer 2 and protective layer 4.
(8) Superconducting wire 100 according to any one of (1) to (7) may further comprise an insulating resin layer 6. Insulating resin layer 6 may have a portion facing second surface 12. Second surface 12 may have a maximum height roughness equal to or smaller than 0.5 times a thickness H2 of insulating resin layer 6 in a direction perpendicular to second surface 12.
(9) Superconducting wire 100 according to any one of (3) to (7) may further comprise insulating resin layer 6. Insulating resin layer 6 may have a portion facing second surface 12. Fourth surface 14 may have a maximum height roughness equal to or smaller than thickness H2 of insulating resin layer 6 in the direction perpendicular to second surface 12.
(10) In superconducting wire 100 according to (9), second surface 12 may have a maximum height roughness equal to or smaller than 0.5 times thickness H2 of insulating resin layer 6 in the direction perpendicular to second surface 12.
(11) According to the present invention, a superconducting device 200 comprises a superconducting wire 100 according to any one of (1) to (10).

### [Detailed Description of Embodiments of the Present Invention]

Hereinafter, embodiments of the present invention will specifically be described with reference to the drawings. In the figures, identical or equivalent components are identically denoted and will not be described repeatedly.

### (First Embodiment)

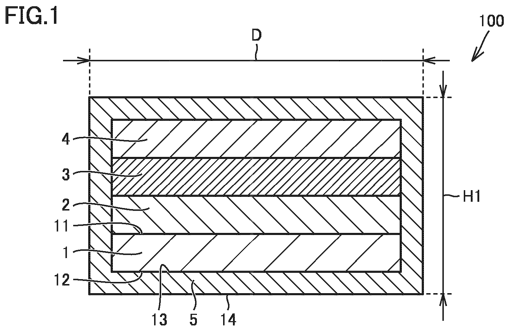

Initially, a configuration of a superconducting wire according to a first embodiment of the present invention will be described. As shown in Fig. 1, a superconducting wire 100 comprises a substrate 1, an intermediate layer 2, a superconducting layer 3, a protective layer 4, and a stabilization layer 5. Intermediate layer 2 is provided on substrate 1. Superconducting layer 3 is provided on intermediate layer 2. From another point of view, intermediate layer 2 is provided between substrate 1 and superconducting layer 3. Protective layer 4 is provided on superconducting layer 3. From another point of view, superconducting layer 3 is provided between intermediate layer 2 and protective layer 4. Stabilization layer 5 surrounds substrate 1, intermediate layer 2, superconducting layer 3, and protective layer 4.

Superconducting wire 100 has a width D for example of 4 mm. Width D may for example be 2 mm or larger and 10 mm or smaller. Superconducting wire 100 has a thickness (a first thickness H1) for example of 0.1 mm. First thickness H1 may for example be 0.05 mm or larger and 0.2 mm or smaller. A value (an aspect ratio) obtained by dividing width D by first thickness H1 is, for example, 10 or larger. Superconducting wire 100 may have an aspect ratio of 50 or larger, or 100 or larger, for example.

Substrate 1 has a first surface 11 and a second surface 12. Second surface 12 is opposite to first surface 11. First surface 11 is a front surface of substrate 1. Second surface 12 is a back surface of substrate 1.

Substrate 1 is a clad material composed of a tape made for example of nickel (Ni), stainless steel or Hastelloy^{®}, and a layer made of copper (Cu) or Ni and provided on the tape. The layer made of Cu or Ni has crystal grains biaxially oriented. In other words, substrate 1 has first surface 11 having crystal grains biaxially oriented therein.

Intermediate layer 2 is in contact with substrate 1 at first surface 11. Intermediate layer 2 includes a seed layer (not shown), a diffusion barrier layer (not shown), and a lattice matching layer (not shown). The seed layer is in contact with first surface 11. The seed layer has a role of taking over the orientation of the crystal grains in substrate 1 to epitaxially grow superconducting layer 3. The seed layer is made for example of cerium oxide (CeO₂).

The diffusion barrier layer is provided on the seed layer. The diffusion barrier layer has a function of preventing a metal element included in substrate 1 from diffusing to a side upper than the diffusion barrier layer. In the present specification, the upper side is a direction from second surface 12 toward first surface 11. A lower side is a direction from first surface 11 toward second surface 12. The diffusion barrier layer is made for example of yttria-stabilized zirconia (YSZ).

The lattice matching layer is provided on the diffusion barrier layer. The lattice matching layer has a role of biaxially orienting crystal grains of superconducting layer 3 when superconducting layer 3 is formed by epitaxial growth. The lattice matching layer is made for example of yttrium oxide (Y₂O₃).

Superconducting layer 3 is in contact with intermediate layer 2. Superconducting layer 3 faces first surface 11 of substrate 1. To "face" as used herein includes a case in which two surfaces are in direct contact with each other, and a case in which an object is interposed between two surfaces so as to be in contact with the two surfaces and the two surfaces also face each other in indirect contact with each other. Superconducting layer 3 is made for example of REBCO. REBCO is an oxide superconductor having a composition formula represented by REBa₂Cu₃O_{7-X}. Note that RE in REBCO represents a rare earth element. Specifically, superconducting layer 3 is made of REBCO such as YBCO (YBa₂Cu₃O_{7-X}) or GdBCO (GdBa₂Cu₃O_{7-X}) for example. The rare earth element in the REBCO configuring superconducting layer 3 is at least one element selected from the group consisting of yttrium, lanthanum, neodymium, samarium, europium, gadolinium, dysprosium, holmium, erbium, thulium, lutetium, and ytterbium. The REBCO of superconducting layer 3 has crystal grains biaxially oriented.

Protective layer 4 is in contact with superconducting layer 3. Protective layer 4 has a role of suppressing a chemical reaction that is caused between superconducting layer 3 and another layer to suppress collapse of the composition of superconducting layer 3. Protective layer 4 is made for example of silver (Ag), an Ag alloy, or Cu.

Stabilization layer 5 has a third surface 13 and a fourth surface 14. Third surface 13 faces second surface 12 of substrate 1. Third surface 13 may be in contact with second surface 12 of substrate 1. Fourth surface 14 is opposite to third surface 13. In other words, fourth surface 14 is located below third surface 13. Fourth surface 14 is a back surface of superconducting wire 100.

Stabilization layer 5 has a role of bypassing an overcurrent generated when superconducting layer 3 has a partially unstabilized superconducting state. Stabilization layer 5 is made for example of Cu or a Cu alloy.

### (Surface Texture of Substrate)

Substrate 1 may have second surface 12 with an arithmetic average roughness (Ra) larger than that of first surface 11 of substrate 1. Substrate 1 has second surface 12 with an arithmetic average roughness larger than 0.02 µm. Although the lower limit for the arithmetic average roughness of second surface 12 is not particularly limited, it may for example be 0.03 µm or larger, larger than 0.65 µm, or 1 µm or larger. Second surface 12 has an arithmetic average roughness smaller than 3 µm for example. Although the upper limit for the arithmetic average roughness of second surface 12 is not particularly limited, it may for example be 2 µm or smaller, 1.5 µm or smaller, or 1 µm or smaller. Note that arithmetic average roughness (Ra) is a surface texture parameter defined in JIS (Japanese Industrial Standards) B0601:2013.

Arithmetic average roughness (Ra) is a value determined by the following method. Specifically, initially, a roughness curve is measured using a roughness meter. A portion of the measured roughness curve is extracted. In the measurement direction, the length of the extracted roughness curve is set as a predetermined reference length. An average value in height of the extracted roughness curve is determined. Assuming that the average value in height is 0, with reference thereto, a height at any point on the extracted roughness curve is determined. An average value of irregularities of the extracted roughness curve is defined as an arithmetic average roughness. Specifically, an average value of the extracted roughness curve in height in absolute value is defined as the arithmetic average roughness.

Second surface 12 may have a maximum height roughness (Rz) larger than that of first surface 11. Second surface 12 has a maximum height roughness smaller than 5 µm. Although the upper limit for the maximum height roughness of second surface 12 is not particularly limited, it may for example be 3 µm or smaller, or 1 µm or smaller. Although the lower limit for the maximum height roughness of second surface 12 is not particularly limited, it may for example be 0.1 µm or larger, 0.2 µm or larger, or 0.5 µm or larger. Note that maximum height roughness (Rz) is a surface texture parameter defined in JIS B0601:2013.

Maximum height roughness is a value determined by the following method. Specifically, initially, a roughness curve is measured using a roughness meter. A portion of the measured roughness curve is extracted. In the measurement direction, the length of the extracted roughness curve is set as a predetermined reference length. An average value in height of the extracted roughness curve is determined. Assuming that the average value in height is 0, with reference thereto, a height at any point on the extracted roughness curve is determined. The extracted roughness curve has a highest portion and a deepest portion, and the level of the highest portion (or the height of the highest peak) and the level of the deepest portion (or the depth of the deepest valley) are summed in absolute value to provide maximum height roughness.

The roughness meter can for example be "VK-X3000," a white light interferometer-equipped laser microscope manufactured by Keyence Corporation. From another point of view, for example, second surface 12 can be measured for arithmetic average roughness and maximum height roughness for example with the white light interferometer-equipped laser microscope VK-X3000 manufactured by Keyence Corporation. Similarly, first surface 11 can be measured for arithmetic average roughness and maximum height roughness for example with the white light interferometer-equipped laser microscope VK-X3000 manufactured by Keyence Corporation. Specifically, second surface 12 can be measured for arithmetic average roughness and maximum height roughness after stabilization layer 5 is removed. After stabilization layer 5, protective layer 4, superconducting layer 3, and intermediate layer 2 are removed, first surface 11 can be measured for arithmetic average roughness and maximum height roughness. "VK-X3050" can be used as a measurement unit (or a head unit) for VK-X3000. The objective lens's magnification is set for example to 50 times. The measurement mode is for example a laser confocal mode.

In measuring arithmetic average roughness and maximum height roughness, a surface texture of a surface that is a target for measurement within the range of a field of view of the measurement unit (hereinafter simply referred to as a measured surface) is obtained. The measured surface's inclination is corrected using an image processing function. Thus obtained surface textures are combined together to obtain a surface texture in a range larger than the field of view of the measurement unit (hereinafter simply referred to as a measurement range). Specifically, the measurement range is set to have a vertical length for example equal to or larger than 5 times that of the field of view of the measurement unit. The measurement range is set to have a lateral length for example equal to or larger than 5 times that of the field of view of the measurement unit.

A roughness curve between two points in the obtained surface texture is obtained using a line roughness measurement function. A cutoff value λs is, for example, null. Cutoff value λc is set to 0.08 mm as defined in JIS. The reference length is set for example to be equal to or larger than 5 times cutoff value λc (for example, 0.4 mm or larger). The two points in the obtained surface texture are positionally changed to obtain five roughness curves for example. Arithmetic average roughness and maximum height roughness are determined for each of the five roughness curves. An average value in arithmetic average roughness of the five roughness curves is defined as an arithmetic average roughness of the measured surface. An average value in maximum height roughness of the five roughness curves is defined as a maximum height roughness of the measured surface.

### (Surface Texture of Stabilization Layer)

Stabilization layer 5 has fourth surface 14 with an arithmetic average roughness larger than 0.02 µm for example. Although the lower limit for the arithmetic average roughness of fourth surface 14 is not particularly limited, it may for example be 0.05 µm or larger, 0.1 µm or larger, or 0.5 µm or larger. Fourth surface 14 has an arithmetic average roughness smaller than 1.5 µm for example. Although the upper limit for the arithmetic average roughness of fourth surface 14 is not particularly limited, it may for example be 1.3 µm or smaller, or 1 µm or smaller.

Fourth surface 14 has a maximum height roughness smaller than 8 µm for example. Although the upper limit for the maximum height roughness of fourth surface 14 is not particularly limited, it may for example be 6 µm or smaller, 4 µm or smaller, or 2 µm or smaller. Although the lower limit for the maximum height roughness of fourth surface 14 is not particularly limited, it may for example be 0.2 µm or larger, 0.5 µm or larger, or 1 µm or larger.

As well as first surface 11 and second surface 12, fourth surface 14 can be measured for arithmetic average roughness and maximum height roughness for example with the white light interferometer-equipped laser microscope VK-X3000 manufactured by Keyence Corporation.

### (Method for Manufacturing Superconducting Wire)

Hereinafter a method for manufacturing superconducting wire 100 according to the first embodiment will be described.

Initially, the step of forming a stack of layers is performed. Specifically, substrate 1 is prepared. Substrate 1 has second surface 12 with its Ra and Rz adjusted as described above for example by polishing. Subsequently, intermediate layer 2 is formed on substrate 1 for example by high-frequency sputtering.

Subsequently, superconducting layer 3 is formed on intermediate layer 2. Superconducting layer 3 is formed for example by pulsed laser deposition (PLD), metal organic decomposition (MOD), metal organic chemical vapor deposition (MOCVD), or vacuum deposition.

Subsequently, protective layer 4 is formed on superconducting layer 3. Protective layer 4 is formed for example by sputtering. After protective layer 4 is formed, heat treatment (or oxygen annealing) may be performed in an atmosphere of oxygen. Thus, a stack of layers that is composed of substrate 1, intermediate layer 2, superconducting layer 3, and protective layer 4 is produced. The produced stack of layers may be thinned. Specifically, for example, a stack of layers having a width of 30 mm may be thinned to produce seven stacks of layers having a width of 4 mm. The thinning is done for example by mechanical slitting using a rotary blade or laser slitting using a laser.

Subsequently, the step of forming stabilization layer 5 is performed. Stabilization layer 5 is formed by plating, for example. The plating is done with a plating solution having a composition including 100 g of copper sulfate and 150 g of sulfuric acid per 1 liter of the plating solution, for example. The plating is done by applying a current having a density for example of 1 A/dm² or larger and 10 A/dm² or smaller. Superconducting wire 100 is thus manufactured.

### (Modification of First Embodiment)

Substrate 1 and intermediate layer 2 may not be configured as described above. Substrate 1 may be composed of stainless steel or Hastelloy^{®}. Intermediate layer 2 may include a crystal orientation layer (not shown) and a lattice matching layer (not shown). The crystal orientation layer has a role of controlling crystal grains of the lattice matching layer and those of superconducting layer 3 in orientation. The crystal orientation layer is made for example of gadolinium zirconate (Gd₂Zr₂O₇). Intermediate layer 2 may be formed for example through ion beam assisted deposition (IBAD).

### (Second Embodiment)

Hereinafter, a configuration of superconducting wire 100 according to a second embodiment will be described. The configuration of superconducting wire 100 according to the second embodiment is different from the configuration of superconducting wire 100 according to the first embodiment mainly in that the former has an insulating resin layer 6, and the former has the remainder similar to that of the latter. Hereinafter, a difference from the configuration of superconducting wire 100 according to the first embodiment will mainly be described.

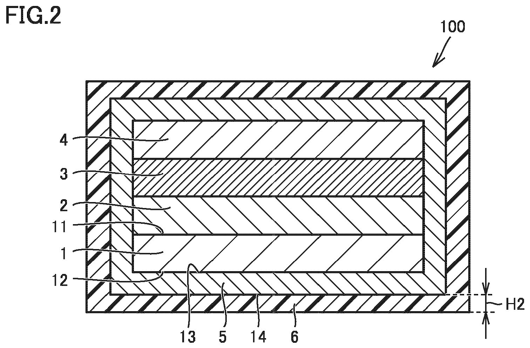

As shown in Fig. 2, superconducting wire 100 may further comprise insulating resin layer 6. Insulating resin layer 6 surrounds stabilization layer 5. From another point of view, insulating resin layer 6 surrounds substrate 1, intermediate layer 2, superconducting layer 3, and protective layer 4. Stabilization layer 5 is located between substrate 1 and insulating resin layer 6. Insulating resin layer 6 is in contact with fourth surface 14 of stabilization layer 5. A portion of insulating resin layer 6 faces second surface 12 of substrate 1.

A thickness of insulating resin layer 6 in a direction perpendicular to second surface 12 is referred to as a second thickness H2. Specifically, second thickness H2 is a thickness of a portion of insulating resin layer 6 facing second surface 12. Second thickness H2 is, for example, 15 µm or smaller. Although the upper limit for second thickness H2 is not particularly limited, it may for example be 10 µm or smaller, or 8 µm or smaller. The smaller second thickness H2 is, the larger a current of a superconducting device manufactured using superconducting wire 100 can be in density. Insulating resin layer 6 is made of an electrically insulating resin such as polyimide or epoxy resin for example.

Second surface 12 has a maximum height roughness for example smaller than second thickness H2. Although the upper limit for the maximum height roughness of second surface 12 is not particularly limited, it may for example be equal to or smaller than 0.5 times second thickness H2, equal to or smaller than 0.25 times second thickness H2, or equal to or smaller than 0.1 times second thickness H2. Although the lower limit for the maximum height roughness of second surface 12 is not particularly limited, it may for example be equal to or larger than 0.01 times second thickness H2 or equal to or larger than 0.05 times second thickness H2.

Fourth surface 14 has a maximum height roughness for example equal to or smaller than second thickness H2. Although the upper limit for the maximum height roughness of fourth surface 14 is not particularly limited, it may for example be equal to or smaller than 0.5 times second thickness H2, or equal to or smaller than 0.25 times second thickness H2. Although the lower limit for the maximum height roughness of fourth surface 14 is not particularly limited, it may for example be equal to or larger than 0.025 times second thickness H2, or equal to or larger than 0.1 times second thickness H2.

### (Third Embodiment)

Hereinafter, a configuration of superconducting wire 100 according to a third embodiment will be described. The configuration of superconducting wire 100 according to the third embodiment is different from the configuration of superconducting wire 100 according to the first embodiment mainly in that protective layer 4 surrounds substrate 1 and superconducting layer 3, and the remainder is similar to that of the configuration of superconducting wire 100 according to the first embodiment. Hereinafter, a difference from the configuration of superconducting wire 100 according to the first embodiment will mainly be described.

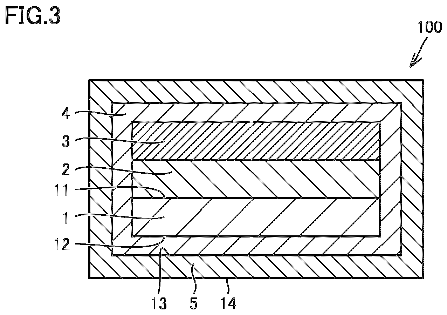

As shown in Fig. 3, protective layer 4 surrounds substrate 1, intermediate layer 2, and superconducting layer 3. Protective layer 4 is in contact with second surface 12 of substrate 1. Protective layer 4 is in contact with third surface 13 of stabilization layer 5. Stabilization layer 5 is separated from second surface 12 of substrate 1 by protective layer 4. Stabilization layer 5 is separated from intermediate layer 2 by protective layer 4. Stabilization layer 5 is separated from superconducting layer 3 by protective layer 4.

### (Fourth Embodiment)

Hereinafter, a configuration of superconducting wire 100 according to a fourth embodiment will be described. The configuration of superconducting wire 100 according to the fourth embodiment is different from the configuration of superconducting wire 100 according to the second embodiment mainly in that protective layer 4 surrounds substrate 1 and superconducting layer 3, and the remainder is similar to that of the configuration of superconducting wire 100 according to the second embodiment. Hereinafter, a difference from the configuration of superconducting wire 100 according to the second embodiment will mainly be described.

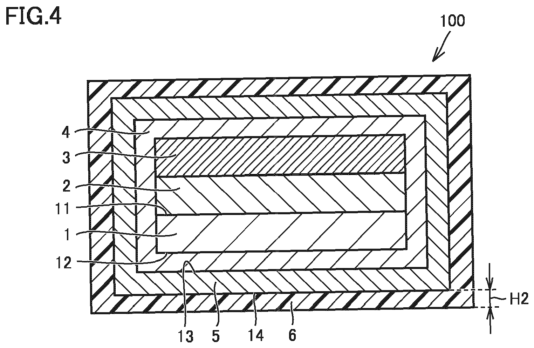

As shown in Fig. 4, protective layer 4 surrounds substrate 1, intermediate layer 2, and superconducting layer 3. Protective layer 4 is in contact with second surface 12 of substrate 1. Protective layer 4 is in contact with third surface 13 of stabilization layer 5. Stabilization layer 5 is separated from second surface 12 of substrate 1 by protective layer 4. Stabilization layer 5 is separated from intermediate layer 2 by protective layer 4. Stabilization layer 5 is separated from superconducting layer 3 by protective layer 4.

### (Fifth Embodiment)

Hereinafter, a configuration of a superconducting device 200 according to a fifth embodiment will be described.

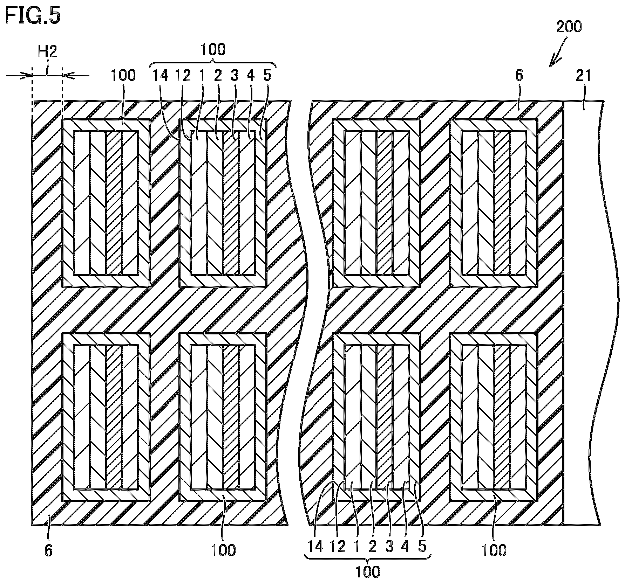

As shown in Fig. 5, superconducting device 200 comprises superconducting wire 100 and a winding frame 21. Superconducting device 200 is, for example, a superconducting coil. Superconducting wire 100 is wound on winding frame 21. Superconducting wire 100 is wound in the form of a double pancake, for example. Specifically, two coil bodies each having superconducting wire 100 wound in the form of a single pancake are stacked in the axial direction of the coil bodies. The two coil bodies are wound in directions opposite to each other. The two coil bodies have their respective radially inner ends electrically connected via a connecting portion (not shown). In other words, the two coil bodies have their respective radially outer ends electrically connected to each other in series.

Superconducting wire 100 has substrate 1 located on a side of superconducting device 200 that is radially outer than superconducting layer 3 for example. In other words, superconducting wire 100 is wound with substrate 1 located on a radially outer side and superconducting layer 3 located on a radially inner side. Superconducting wire 100 may be wound in the form of a single pancake coil.

As shown in Fig. 5, insulating resin layer 6 surrounds superconducting wire 100 wound. According to the present embodiment, a thickness of that portion of insulating resin layer 6 facing second surface 12 in a direction perpendicular to second surface 12 which is the smallest in thickness is defined as second thickness H2. Superconducting wire 100 wound on winding frame 21 is impregnated with resin and subsequently the resin is set to form insulating resin layer 6.

While a case in which superconducting device 200 is a superconducting coil has been described above, superconducting device 200 is not limited to a superconducting coil. Superconducting device 200 may for example be a superconducting cable.

Hereinafter, a function and effect of superconducting wire 100 according to the present disclosure will be described.

Typically, superconducting wire 100 is used in a state in which insulating resin layer 6 partially facing second surface 12 of substrate 1 is formed. Generally, in use, superconducting wire 100 is cooled by a coolant such as liquid nitrogen, and after use, superconducting wire 100 is returned to room temperature. Insulating resin layer 6 may peel off stabilization layer 5 when insulating resin layer 6 shrinks as environmental temperature varies.

As a result of a variety of studies on peeling of insulating resin layer 6, the inventor has found that a surface texture of second surface 12 of substrate 1 affects peeling of insulating resin layer 6. Arithmetic average roughness of second surface 12 affects a surface texture of another layer surrounding substrate 1. Specifically, when second surface 12 has an excessively small arithmetic average roughness, for example, stabilization layer 5 will have fourth surface 14 with an excessively small arithmetic average roughness. In this case, fourth surface 14 is excessively smooth and thus exhibits an insufficient anchoring effect, resulting in insulating resin layer 6 peeling. Note that an anchoring effect means that, for example, insulating resin layer 6 enters irregularities of fourth surface 14 and thus bites into fourth surface 14 to join fourth surface 14 with effectively enhanced force.

According to the present invention, superconducting wire 100 has substrate 1 with second surface 12 having an arithmetic average roughness larger than 0.02 µm. This prevents second surface 12 from having an excessively small arithmetic average roughness. This can in turn prevent stabilization layer 5 from having fourth surface 14 with an excessively small arithmetic average roughness. Therefore, an anchoring effect between stabilization layer 5 and insulating resin layer 6 is sufficiently exhibited, and peeling of insulating resin layer 6 can be suppressed.

When second surface 12 has an excessively large maximum height roughness, fourth surface 14 will have a large maximum height roughness. When fourth surface 14 has an excessively large maximum height roughness, fourth surface 14 has a locally protruding portion. As a result, a hole is easily formed in insulating resin layer 6 around the protruding portion.

According to the present invention, superconducting wire 100 has substrate 1 with second surface 12 having a maximum height roughness smaller than 5 µm. This prevents second surface 12 from having an excessively large maximum height roughness. This can in turn prevent stabilization layer 5 from having fourth surface 14 with an excessively large maximum height roughness, and thus suppress formation of a hole in insulating resin layer 6.

When second surface 12 has an excessively large arithmetic average roughness, fourth surface 14 will have a large arithmetic average roughness. When fourth surface 14 has an excessively large arithmetic average roughness, fourth surface 14 entirely has irregularities. This forms small gaps between stabilization layer 5 and insulating resin layer 6. When superconducting wire 100 is cooled by liquid nitrogen, the liquid nitrogen seeps into the gaps. When superconducting wire 100 returns to room temperature, the liquid nitrogen having seeped evaporates and thus inflates insulating resin layer 6.

Optionally, superconducting wire 100 has substrate 1 with second surface 12 having an arithmetic average roughness smaller than 3 µm. This prevents second surface 12 from having an excessively large arithmetic average roughness. This can prevent stabilization layer 5 from having fourth surface 14 with an excessively large arithmetic average roughness and thus suppress inflation of insulating resin layer 6.

Optionally, superconducting wire 100 has stabilization layer 5 with fourth surface 14 having an arithmetic average roughness larger than 0.02 µm. This prevents fourth surface 14 from having an excessively small arithmetic average roughness. This can suppress peeling of insulating resin layer 6.

Optionally, superconducting wire 100 has stabilization layer 5 with fourth surface 14 having an arithmetic average roughness smaller than 1.5 µm. This prevents fourth surface 14 from having an excessively large arithmetic average roughness. This can suppress inflation of insulating resin layer 6.

Optionally, superconducting wire 100 has stabilization layer 5 with fourth surface 14 having a maximum height roughness smaller than 8 µm. This prevents fourth surface 14 from having an excessively large maximum height roughness. This can suppress formation of a hole in insulating resin layer 6.

Optionally, superconducting wire 100 has substrate 1 with second surface 12 having a maximum height roughness equal to or smaller than 0.5 times second thickness H2 of insulating resin layer 6. When second surface 12 has a maximum height roughness at an excessively large ratio to second thickness H2, fourth surface 14 will have a maximum height roughness at a large ratio to second thickness H2. This facilitates forming a hole in insulating resin layer 6. Optionally, superconducting wire 100 is prevented from having second surface 12 with a maximum height roughness at an excessively large ratio to second thickness H2. This can suppress formation of a hole in insulating resin layer 6.

Optionally, superconducting wire 100 has fourth surface 14 with a maximum height roughness equal to or smaller than second thickness H2 of insulating resin layer 6. This prevents fourth surface 14 from having a maximum height roughness at an excessively large ratio to second thickness H2. This can suppress formation of a hole in insulating resin layer 6.

According to the present invention, superconducting device 200 comprises superconducting wire 100 according to the present invention. This can suppress peeling of insulating resin layer 6.

### (Example)

### (Preparing Samples)

**[Table 1]**

| sample No. | thickness of insulating resin layer (H2) | 2nd surface of substrate | | | 4th surface of stabilization layer | | |
|---|---|---|---|---|---|---|---|
| | | Ra | Rz | Rz/H2 | Ra | Rz | Rz/H2 |
| | [µm] | [µm] | [µm] | - | [µm] | [µm] | - |
| sample 1 | 8 | 0.02 | 0.1 | 0.013 | 0.01 | 0.2 | 0.025 |
| sample 2 | 8 | 0.03 | 0.1 | 0.013 | 0.03 | 0.2 | 0.025 |
| sample 3 | 8 | 0.05 | 0.2 | 0.025 | 0.07 | 0.3 | 0.038 |
| sample 4 | 8 | 0.5 | 0.7 | 0.088 | 0.4 | 1 | 0.13 |
| sample 5 | 8 | 2 | 3 | 0.38 | 1 | 5 | 0.63 |
| sample 6 | 8 | 3 | 4.5 | 0.56 | 1.5 | 7 | 0.88 |
| sample 7 | 8 | 2 | 5 | 0.63 | 1.2 | 8 | 1 |
| sample 8 | 2 | 0.03 | 0.1 | 0.05 | 0.03 | 0.2 | 0.1 |
| sample 9 | 2 | 1.5 | 1 | 0.5 | 1 | 2 | 1 |
| sample 10 | 2 | 2 | 2 | 1 | 1.2 | 3 | 1.5 |

Hereinafter, a test using samples will be described. Initially, superconducting wires 100 according to Samples 1 to 10 were prepared. Samples 1 and 7 are comparative examples. Samples 2 to 6 and 8 to 10 are examples.

Superconducting wires 100 according to Samples 1 to 10 were each manufactured in the manufacturing method according to the second embodiment described above. Specifically, initially, substrate 1 was prepared. Substrate 1 had a thickness of 100 µm. Substrate 1 had a width of 30 mm. Substrate 1 had a length of 100 m. Substrate 1 was a clad material including a tape made of stainless steel, and a Cu layer and a Ni layer provided on the tape.

Subsequently, intermediate layer 2 was formed on substrate 1 by sputtering. Intermediate layer 2 had a thickness of 0.5 µm. Intermediate layer 2 included a seed layer composed of CeO₂. The seed layer had a thickness of 0.1 µm. Intermediate layer 2 included a diffusion barrier layer composed of YSZ. The diffusion barrier layer had a thickness of 0.2 µm. Intermediate layer 2 included a lattice matching layer composed of Y₂O₃. The lattice matching layer had a thickness of 0.2 µm.

Subsequently, superconducting layer 3 was formed by the PLD method. Superconducting layer 3 was composed of GdBCO. Superconducting layer 3 had a thickness of 3 µm. Subsequently, protective layer 4 was formed by sputtering. Protective layer 4 had a thickness of 3 µm. A stack of layers composed of substrate 1, intermediate layer 2, superconducting layer 3 and protective layer 4, and having a width of 30 mm, was thinned. Specifically, it was subjected to mechanical slitting and thus thinned to have a width of 4 mm.

Subsequently, the stack of layers had an external surface plated to form stabilization layer 5. The plating was done with a plating solution having a composition including 100 g of copper sulfate and 150 g of sulfuric acid per 1 liter of the plating solution. The plating was done with a current having a density of 10 A/dm².

Subsequently, stabilization layer 5 had an external surface coated with polyimide to form insulating resin layer 6. Superconducting wires 100 according to Samples 1 to 10 were thus produced.

As shown in Table 1, Samples 1 to 7 had insulating resin layer 6 with a thickness (i.e., second thickness H2) of 8 µm. Samples 8 to 10 had second thickness H2 of 2 µm.

Samples 1 to 7 had second surface 12 with an arithmetic average roughness of 0.02 µm or larger and 3 µm or smaller. Samples 1 to 7 had second surface 12 with a maximum height roughness of 0.1 µm or larger and 5 µm or smaller. Samples 1 to 7 had fourth surface 14 with an arithmetic average roughness of 0.01 µm or larger and 1.5 µm or smaller. Samples 1 to 7 had fourth surface 14 with a maximum height roughness of 0.2 µm or larger and 8 µm or smaller.

Samples 8 to 10 had second surface 12 with an arithmetic average roughness of 0.03 µm or larger and 2 µm or smaller. Samples 8 to 10 had second surface 12 with a maximum height roughness of 0.1 µm or larger and 2 µm or smaller. Samples 8 to 10 had fourth surface 14 with an arithmetic average roughness of 0.03 µm or larger and 1.2 µm or smaller. Samples 8 to 10 had fourth surface 14 with a maximum height roughness of 0.2 µm or larger and 3 µm or smaller.

### (Evaluation Method)

All of the samples had insulating resin layer 6 subjected to a heat cycle evaluation. Specifically, superconducting wire 100 was immersed in liquid nitrogen for about 1 minute and thus cooled and subsequently removed therefrom and returned to room temperature, and this operation was repeated five times. Thereafter, whether or not insulating resin layer 6 inflated, had a hole and peeled was visually examined.

Furthermore, all of the samples had superconducting wire 100 measured for a critical current value (Ic). Specifically, critical current value Ic was measured before and after the above-described heat cycle evaluation. In measuring critical current value Ic, superconducting wire 100 was cooled to 77 K by immersion in liquid nitrogen. Superconducting wire 100 had critical current value Ic measured in a self-magnetic field. Note that a self-magnetic field means a state in which there is no externally applied magnetic field received.

### (Evaluation Results)

**[Table 2]**

| sample No. | inflation | hole | peeling | critical current value [A/cm] | |
|---|---|---|---|---|---|
| | | | | before evaluation | after evaluation |
| sample 1 | absent | absent | present | 501 | 81 |
| sample 2 | absent | absent | absent | 510 | 508 |
| sample 3 | absent | absent | absent | 506 | 506 |
| sample 4 | absent | absent | absent | 495 | 497 |
| sample 5 | absent | absent | absent | 504 | 505 |
| sample 6 | present | absent | absent | 499 | 210 |
| sample 7 | absent | present | absent | 497 | 198 |
| sample 8 | absent | absent | absent | 512 | 512 |
| sample 9 | absent | absent | absent | 502 | 501 |
| sample 10 | absent | present | absent | 505 | 219 |

As shown in Table 2, it has been confirmed that Sample 1 had insulating resin layer 6 peeled. It has been confirmed that Sample 6 had insulating resin layer 6 inflated. It has been confirmed that Samples 7 and 10 had insulating resin layer 6 with a hole formed therein. As shown in Table 2, when the samples confirmed to have insulating resin layer 6 inflated, having a hole, or peeled (i.e., Samples 1, 6, 7, and 10) were compared with the other samples, it has been confirmed that the former presented reduction of critical current value Ic after the heat cycle evaluation.

Further, when the sample confirmed to have insulating resin layer 6 peeled (i.e., Sample 1) was compared with the samples confirmed to have insulating resin layer 6 inflated or having a hole (i.e., Samples 6, 7, and 10), it has been confirmed that the former had critical current value Ic reduced in a large amount after the heat cycle evaluation.

According to the above results, it has been confirmed that second surface 12 having an arithmetic average roughness larger than 0.02 µm and smaller than 3 µm and a maximum height roughness smaller than 5 µm and also equal to or smaller than 0.5 times thickness H2 of insulating resin layer 6 (i.e., Samples 2 to 5, 8, and 9) can suppress inflation of, formation of a hole in, and peeling of insulating resin layer 6, and hence reduction of critical current value Ic.

The presently disclosed embodiments and examples are illustrative in any respects and should not be construed as being restrictive. The scope of the present invention is defined by the terms of the claims, rather than the embodiments described above.

### REFERENCE SIGNS LIST

1 substrate, 2 intermediate layer, 3 superconducting layer, 4 protective layer, 5 stabilization layer, 6 insulating resin layer, 11 first surface, 12 second surface, 13 third surface, 14 fourth surface, 21 winding frame, 100 superconducting wire, 200 superconducting device, D width, H1 first thickness, H2 second thickness.

## Claims

1. A superconducting wire (100) comprising:
a substrate (1) including a first surface (11) and a second surface (12) opposite to the first surface; and
a superconducting layer (3) facing the first surface,
**characterised in that** the second surface (12) has an arithmetic average roughness larger than 0.02 µm and
a maximum height roughness smaller than 5 µm.

2. The superconducting wire according to claim 1, wherein the second surface has an arithmetic average roughness smaller than 3 µm.

3. The superconducting wire according to claim 1 or 2, further comprising a stabilization layer (5) that surrounds the substrate and the superconducting layer, wherein the stabilization layer includes a third surface (13) facing the second surface and a fourth surface (14) opposite to the third surface.

4. The superconducting wire according to claim 3, wherein the fourth surface has an arithmetic average roughness larger than 0.02 µm.

5. The superconducting wire according to claim 3 or 4, wherein the fourth surface has an arithmetic average roughness smaller than 1.5 µm.

6. The superconducting wire according to any one of claims 3 to 5, wherein the fourth surface has a maximum height roughness smaller than 8 µm.

7. The superconducting wire according to any one of claims 3 to 6, further comprising:
an intermediate layer (2) provided between the substrate and the superconducting layer; and
a protective layer (4) provided on the superconducting layer, wherein
the stabilization layer surrounds the intermediate layer and the protective layer.

8. The superconducting wire according to any one of claims 1 to 7, further comprising an insulating resin layer (6), wherein
the insulating resin layer includes a portion facing the second surface, and
the second surface has a maximum height roughness equal to or smaller than 0.5 times a thickness (H2) of the insulating resin layer in a direction perpendicular to the second surface.

9. The superconducting wire according to any one of claims 3 to 7, further comprising an insulating resin layer (6), wherein
the insulating resin layer includes a portion facing the second surface, and
the fourth surface has a maximum height roughness equal to or smaller than a thickness (H2) of the insulating resin layer in a direction perpendicular to the second surface.

10. The superconducting wire according to claim 9, wherein the second surface has a maximum height roughness equal to or smaller than 0.5 times the thickness of the insulating resin layer in the direction perpendicular to the second surface.

11. A superconducting device (200) comprising the superconducting wire according to any one of claims 1 to 10.

## Patentansprüche

1. Supraleitender Draht (100), umfassend ein Substrat (1), das eine erste Fläche (11) und eine zweite Fläche (12) gegenüber der ersten Fläche umfasst; und
eine zur ersten Fläche zeigende supraleitende Schicht (3),
**dadurch gekennzeichnet, dass** die zweite Fläche (12) eine arithmetische mittlere Rauigkeit von mehr als 0,02 µm und eine maximale Höhenrauigkeit von weniger als 5 µm aufweist.

2. Supraleitender Draht nach Anspruch 1, wobei die zweite Fläche eine arithmetische mittlere Rauigkeit von weniger als 3 µm aufweist.

3. Supraleitender Draht nach Anspruch 1 oder 2, ferner umfassend eine Stabilisierungsschicht (5), die das Substrat und die supraleitende Schicht umgibt, wobei die Stabilisierungsschicht eine dritte Fläche (13), die zur zweiten Fläche zeigt, und eine vierte Fläche (14) gegenüber der dritten Fläche aufweist.

4. Supraleitender Draht nach Anspruch 3, wobei die vierte Fläche eine arithmetische mittlere Rauigkeit von mehr als 0,02 µm aufweist.

5. Supraleitender Draht nach Anspruch 3 oder 4, wobei die vierte Fläche eine arithmetische mittlere Rauigkeit von weniger als 1,5 µm aufweist.

6. Supraleitender Draht nach einem der Ansprüche 3 bis 5, wobei die vierte Fläche eine maximale Höhenrauigkeit von weniger als 8 µm aufweist.

7. Supraleitender Draht nach einem der Ansprüche 3 bis 6, ferner umfassend:
eine Zwischenschicht (2), angeordnet zwischen dem Substrat und der supraleitenden Schicht; und
eine Schutzschicht (4), angeordnet auf der supraleitenden Schicht, wobei die Stabilisierungsschicht die Zwischenschicht und die Schutzschicht umgibt.

8. Supraleitender Draht nach einem der Ansprüche 1 bis 7, ferner umfassend eine Isolierharzschicht (6), wobei die Isolierharzschicht einen zur zweiten Fläche zeigenden Abschnitt umfasst, und
die zweite Fläche eine maximale Höhenrauigkeit aufweist, die gleich oder kleiner ist als das 0,5-fache einer Dicke (H2) der Isolierharzschicht in einer Richtung senkrecht zur zweiten Fläche.

9. Supraleitender Draht nach einem der Ansprüche 3 bis 7, ferner umfassend eine Isolierharzschicht (6), wobei die Isolierharzschicht einen zur zweiten Fläche zeigenden Abschnitt umfasst, und
die vierte Fläche eine maximale Höhenrauigkeit aufweist, die gleich oder kleiner ist als eine Dicke (H2) der Isolierharzschicht in einer Richtung senkrecht zur zweiten Fläche.

10. Supraleitender Draht nach Anspruch 9, wobei die zweite Fläche eine maximale Höhenrauigkeit aufweist, die gleich oder kleiner ist als das 0,5-fache der Dicke der Isolierharzschicht in der Richtung senkrecht zur zweiten Fläche.

11. Supraleitende Vorrichtung (200), umfassend den supraleitenden Draht nach einem der Ansprüche 1 bis 10.

## Revendications

1. Fil supraconducteur (100) comprenant :
un substrat (1) incluant une première surface (11) et une deuxième surface (12) opposée à la première surface ; et
une couche supraconductrice (3) orientée vers la première surface,
**caractérisé en ce que** la deuxième surface (12) présente une rugosité moyenne arithmétique supérieure à 0,02 µm et une rugosité en hauteur maximale inférieure à 5 µm.

2. Le fil supraconducteur selon la revendication 1, dans lequel la deuxième surface présente une rugosité moyenne arithmétique inférieure à 3 µm.

3. Le fil supraconducteur selon la revendication 1 ou 2, comprenant en outre une couche de stabilisation (5) qui entoure le substrat et la couche supraconductrice, dans lequel la couche de stabilisation inclut une troisième surface (13) orientée vers la deuxième surface, et une quatrième surface (14) opposée à la troisième surface.

4. Le fil supraconducteur selon la revendication 3, dans lequel la quatrième surface présente une rugosité moyenne arithmétique inférieure à 0,02 µm.

5. Le fil supraconducteur selon la revendication 3 ou 4, dans lequel la quatrième surface présente une rugosité moyenne arithmétique inférieure à 1,5 µm.

6. Le fil supraconducteur selon l'une quelconque des revendications 3 à 5, dans lequel la quatrième surface présente une rugosité en hauteur maximale inférieure à 8 µm.

7. Le fil supraconducteur selon l'une quelconque des revendications 3 à 6, comprenant en outre :
une couche intermédiaire (2) disposée entre le substrat et la couche supraconductrice ; et
une couche protectrice (4) disposée sur la couche supraconductrice, dans lequel
la couche de stabilisation entoure la couche intermédiaire et la couche protectrice.

8. Le fil supraconducteur selon l'une quelconque des revendications 1 à 7, comprenant en outre une couche de résine isolante (6) dans lequel
la couche de résine isolante inclut une partie orientée vers la deuxième surface, et
la deuxième surface présente une rugosité en hauteur maximale inférieure ou égale à 0,5 fois une épaisseur (H2) de la couche de résine isolante dans une direction perpendiculaire à la deuxième surface.

9. Le fil supraconducteur selon l'une quelconque des revendications 3 à 7, comprenant en outre une couche de résine isolante (6) dans lequel
la couche de résine isolante inclut une partie orientée vers la deuxième surface, et
la quatrième surface présente une rugosité en hauteur maximale inférieure ou égale à une épaisseur (H2) de la couche de résine isolante dans une direction perpendiculaire à la deuxième surface.

10. Le fil supraconducteur selon la revendication 9, dans lequel
la deuxième surface présente une rugosité en hauteur maximale inférieure ou égale à 0,5 fois l'épaisseur de la couche de résine isolante dans une direction perpendiculaire à la deuxième surface.

11. Dispositif supraconducteur (200) comprenant le fil supraconducteur selon l'une quelconque des revendications 1 à 10.
